(19) Europäisches Patentamt
European Patent Office
Office européen des brevets

(11) **EP 1 201 604 B1**

(12) **EUROPEAN PATENT SPECIFICATION**

(45) Date of publication and mention
of the grant of the patent:
**07.04.2010 Bulletin 2010/14**

(51) Int Cl.:
***B81C 1/00*** *(2006.01)* ***H01L 29/04*** *(2006.01)*

(21) Application number: **01870213.4**

(22) Date of filing: **08.10.2001**

(54) **A method for producing micromachined devices**

Verfahren zur Herstellung von mikrobearbeiteten Anordnungen

Procédé de fabrication de dispositifs micro-usinés

(84) Designated Contracting States:
**AT BE CH CY DE DK ES FI FR GB GR IE IT LI LU MC NL PT SE TR**

(30) Priority: **09.10.2000 EP 00870227**
**10.10.2000 US 239226 P**

(43) Date of publication of application:
**02.05.2002 Bulletin 2002/18**

(73) Proprietors:
• **IMEC**
**3001 Leuven (BE)**
• **Eastman Kodak Company**
**Rochester NY 14650-2201 (US)**

(72) Inventors:
• **Wivrouw, Ann**
**3020 Herent (BE)**
• **De Vries, Atze**
**3000 Leuven (BE)**

• **De Moor, Piet**
**3210 Linden-Lubbeek (BE)**
• **Haspelagh, Luc**
**3210 Linden-Lubbeek (BE)**
• **Parmentier, Brigitte**
**3001 Leuven (BE)**
• **Verbist, Agnes**
**3020 Winkelse-Herent (BE)**
• **Anagnostopoulos, Constantine Mendon,**
**New York 14506 (US)**

(74) Representative: **Van Malderen, Joëlle et al**
**pronovem - Office Van Malderen**
**Avenue Josse Goffin 158**
**1082 Bruxelles (BE)**

(56) References cited:
**EP-A- 0 658 927     EP-A- 1 130 631**
**DE-A- 3 435 138     US-A- 4 278 987**
**US-A- 4 969 359**

**Description**

**Field of the invention**

The present invention is related to a method for producing micromachined devices for use in Microelectromechanical Systems (MEMS). The present invention is also related to the devices obtained by said method and the use of said devices.

**State of the art**

In Microelectromechanical Systems (MEMS), also known as Microsystems or Micro Machined Systems, devices are often used, the production of which is based on the method technology developed in semiconductor processing, combined with specific MEMS technology. In MEMS technology, structures such as beams or cavities, can be added to micro-electronic circuitry. Compared to standard semiconductor devices, the mechanical properties of these micromachined devices are subject to very demanding criteria, in terms of breaking behaviour, weight, vibration resistance, etc, which is imposing higher standards on the processing of these devices.

To produce certain types of micromachined devices, the method of bulk micromachining is used, wherein wells are etched in a semiconductor wafer, leaving membranes, openings or beams. This leads for example to pressure sensors, accelerometers, inclinometers, or optical devices.

In the case of bulk micromachined accelerometers for example, openings are etched in the semiconductor wafer. Often, these openings are large and narrow, resembling elongated cracks in the wafer.

In general, it is true that cavities or openings are formed in micromachined devices, which are large and deep in comparison to openings normally defined in semiconductor processing, such as contact or via holes, which have a diameter typically less than 5 $\mu$m and a depth less than 2$\mu$m. Such large openings or cavities are responsible for a weakening of the wafer and increase the chance of the wafer breaking under the influence of stresses induced for example during processing.

It is known in the state of the art to exploit certain qualities related to the crystal structure of a semiconductor, in particular a Si wafer. For example, the etching of openings parallel to the <100> direction is beneficial in the case of anistropic wet etching steps. This is described in documents EP-A-0658927 and US-A-4969359 for example. However, narrow openings parallel to the <100> direction tend to weaken the wafer considerably, and increase the danger of unintended breaking by cleavage during processing.

In document EP-A-0562880, a semiconductor infra-red emitting device or LED on a substrate is described, the substrate being slanted with respect to the LED stack. The slanted orientation of the devices on the substrate is meant to obtain cleavage of the substrate in a predefined way. This document is not related to avoiding cleavage and thus mechanical failure, but to obtaining this cleavage. Neither is this document related to the production of MEMS, comprising openings or cavities. It is merely a way of dividing a wafer into separate devices by way of cleavage. The same is true of the document DE-A-3435138, which describes a way of obtaining single chips by cleavage, with a reduced risk of splitting a wafer along a second direction perpendicular to the intended direction.

Document US-A-4278987 describes a semiconductor device prepared according to a method wherein a dent is etched and subsequently filled, said dent having a polygonal shape having main sides parallel to a direction along <100> or inclined within 25° with respect to <100>. The purpose for this slanted position is not for mechanical strength purposes, but for epitaxial growth and planarization purposes. Devices according to this document are not MEMS.

Document JP-A-03219618 is related to cleaving wafers for SEM inspection. Crystal structure orientation is used to obtain cleavage through a device, not to prevent it.

The US-A-4 969 359 is also relevant as prior art.

**Aims of the invention**

The present invention aims to provide a method for producing micromachined devices which have a higher resistance to crack propagation during and after processing.

A further aim of the present invention is to provide micromachined devices having improved resistance to crack propagation.

**Summary of the invention**

The present invention is related to a method for producing micromachined devices for use in Microelectromechanical Systems (MEMS), as defined in the appended claims.

The present invention is related in particular to a method, wherein said wafer has the shape of a circular disc, with at least one part cut off along a chord of said circular disc, the longest of said chords being called 'the flat' of said wafer.

According to a first preferred embodiment of the present invention, said flat is not parallel to said intersection.

According to a second preferred embodiment of the present invention, said flat is parallel to said intersection.

In the present invention, said wafer is a silicon wafer, whose front and back surfaces are oriented along a plane of the {100} family and wherein said cleavage plane is a plane belonging to the {111} or the {110} family. In these latter cases, said angle between said longitudinal axis of said opening and/or cavity and said direction is less than 44°.

In the embodiment wherein said flat is oriented along said intersection, the method according to the invention comprises the steps of:

- subjecting said wafer to a photolithography step, whereby a pattern is printed through a mask onto said wafer,
- etching said wafer,

wherein said photolithography step comprises the step of rotating said mask over an angle, with respect to said wafer, or wherein said pattern is positioned at an angle with respect to said mask, or wherein said photolithography step comprises the step of rotating said wafer over an angle with respect to said mask.

According to the embodiment wherein said flat is oriented along said intersection, said photolithography step may comprise a contact printing step or a proximity printing step.

In the embodiment wherein said flat is not oriented along said intersection, the method according to the invention comprises the steps of:

- subjecting said wafer to a photolithography step, whereby a pattern is printed through a mask onto said wafer,
- etching said wafer,

wherein said photolithography step may comprise a contact printing step, a proximity printing step or a number of projection printing steps.

## Short description of the drawings

Figure 1a describes the orientation of the dies on a standard {100} Si-wafer in standard processing.

Figure 1b describes an alternative form of a standard {100} Si-wafer.

Figure 1c shows an alternative pattern of devices on a standard wafer.

Figure 2a shows a standard {100} Si-wafer with a long and narrow opening etched out.

Figure 2b shows the wafer of figure 2a, after cleavage.

Figure 3a shows a standard {100} Si-wafer wherein the device to be produced is tilted over an angle θ with respect to the flat.

Figure 3b shows the situation of fig. 3a wherein θ = 45°.

Figure 4 shows a wafer wherein the device is parallel to the flat, but device and flat are tilted over an angle θ with respect to <110>.

Figure 5 shows a wafer wherein dies are printed using a step-and-repeat projection printing step in the photolithography.

## Detailed description of the invention

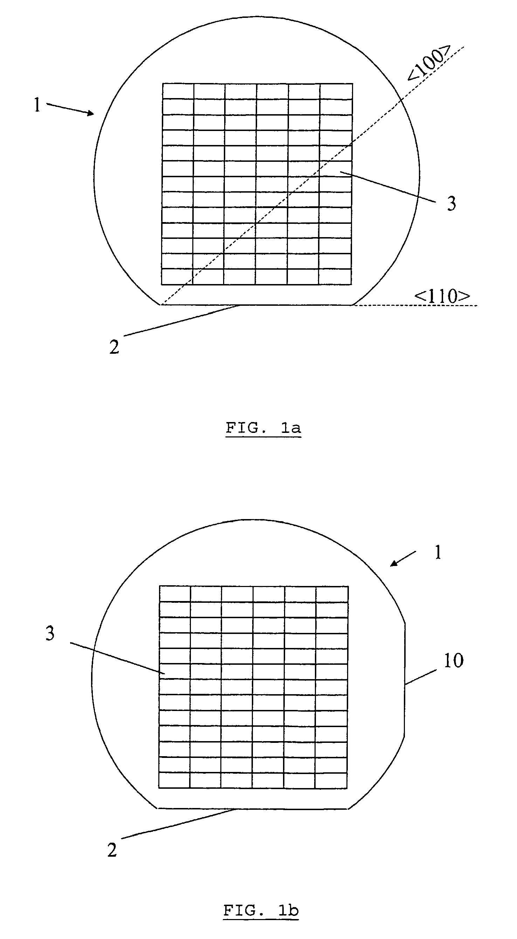

As shown in figure 1a, semiconductor wafers are mostly delivered in the form of circular shaped flat discs 1, with a straight edge or 'flat' 2 along a chord of the circular disc, said flat being used for positioning the wafer during processing. An additional straight edge 10 may be present, as shown in figure 1b, which is however shorter in length than the flat 2. In the following, the term 'flat' refers to the longest straight edge of a wafer.

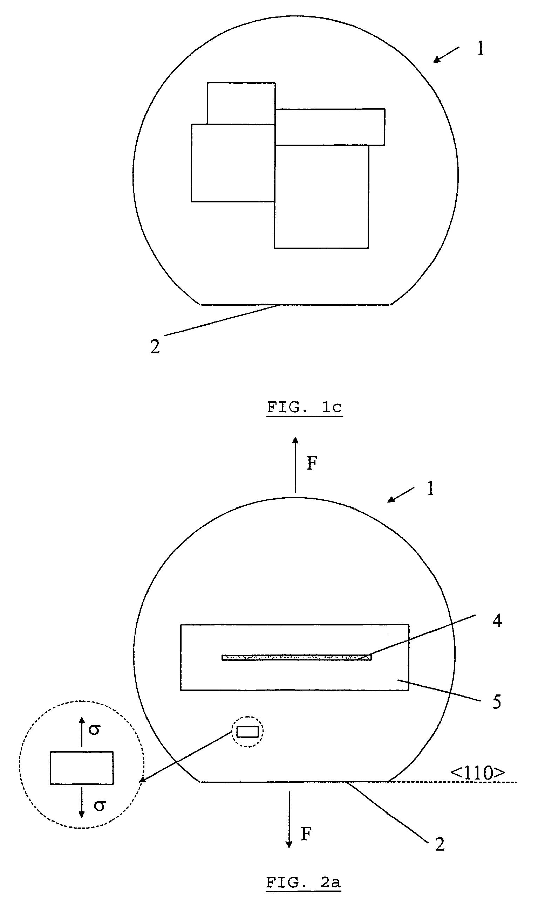

In the case of standard semiconductor devices, a wafer is partitioned into a number of 'dies' 3, which, after processing, will be separated to yield single chips. The partitioning into dies of equal dimensions is typical for devices produced on the basis of a projection printing process, such as step-and-repeat printing. Other printing processes, such as those using a contact or proximity printer, allow other configurations, such as the one shown in figure 1c. We will however base the following description on the exemplary case of figure 2a, wherein the micromachining consists of producing a device 5 containing a long and narrow opening 4, from a wafer 1 with flat 2.

Under the influence of a load applied to the wafer, such as mechanical or thermal forces or shocks, the opening 4 may propagate, leading to breaking of the wafer. Breaking will occur along a so-called cleavage plane. The question whether or not the wafer will break and along which cleavage plane, depends on the form of the opening, the stress applied, and on the orientation of the wafer's crystal structure with respect to the opening. It is the stress concentration around crack tips or other discontinuities which causes wafers to break even though they are subjected to an overall

3

stress level, which is far below the material's yield strength.

In general, when a crack of length 2c is formed in a material, subjected to a stress σ in the homogenous material, a stress intensity factor K is used, to numerically evaluate the eventuality of crack propagation. This will be illustrated (see figure 2a) for the exemplary case of a tensile stress σ in a silicon wafer, caused by external tensile forces F. It is understood that the stress σ is the tensile stress in the homogenous material, at a sufficiently large distance from the opening 4. It is a known fact that in the vicinity of discontinuities (sharp edges, crack tips) the stress level will rise to very high local values, exceeding by far the value σ in the homogenous material. This is why, at acceptable levels of the stress in the homogenous material, breaking of the wafer can be initiated at the edges of openings such as opening 4.

This stress intensity factor K (expressed in $MPA\sqrt{m}$) is given by

$$K = \sigma\sqrt{c\pi} \qquad\qquad (1)$$

Once the stress intensity factor exceeds a critical value $K_c$, the crack will be propagated. This can equally be expressed in terms of a critical applied stress level $\sigma_c$ in the homogenous material:

$$\sigma_c = \frac{K_c}{\sqrt{c\pi}} \qquad\qquad (2)$$

When σ exceeds $\sigma_c$, crack propagation begins.

In micromachined devices, silicon is a widely used material. It has excellent mechanical properties apart from significant photoelectric and thermoelectric effects and a reasonable carrier mobility.

Many of these properties are related to the crystalline structure of silicon. The atoms in a silicon wafer form a lattice structure, which, viewed from different angles reveals different patterns of atoms. The planes and directions in a Si-wafer are represented by their Miller indices, which are known in the art.

Three families of planes: {100}, {110} and {111} are important in silicon wafers. Standard Si-wafers are of the {100} type, meaning that their flat front and back surfaces are oriented along a plane belonging to the {100} family. Also in standard Si-wafers, the flat 2 is oriented along a <110> direction which is the common intersection direction between on the one hand planes of the {100} and {110} families and on the other hand of planes of the {100} and {111} families. Figure 1a also shows the <100> direction, which is the common intersection between on the one hand two planes of the {100} family and on the other hand planes of the {100} and {110} families. The failure of Si-wafers as a consequence of the stress concentrations described above, occurs by a phenomenon called cleavage: this means that the wafer breaks in two along a well defined cleavage plane that depends on the orientation of the stress with respect to the wafer's crystal structure.

In silicon, the value of $K_c$ has been measured for cleavage along the three main Miller index plane families, resulting in the data of table 1 (P.J. Burnett, 'Properties of Silicon', EMIS datareview series no. 4, INSPEC, London, UK, 1988, p. 30). This can be interpreted as the likelihood of the wafer cleaving along a plane belonging to each of the three families mentioned.

It is clear that the {100} family offers the most resistance to cleavage in the presence of a stress concentration, followed by {110} and {111} in that order. However, this doesn't mean that cleavage necessarily occurs along a plane of the {111} family, as will be explained after this.

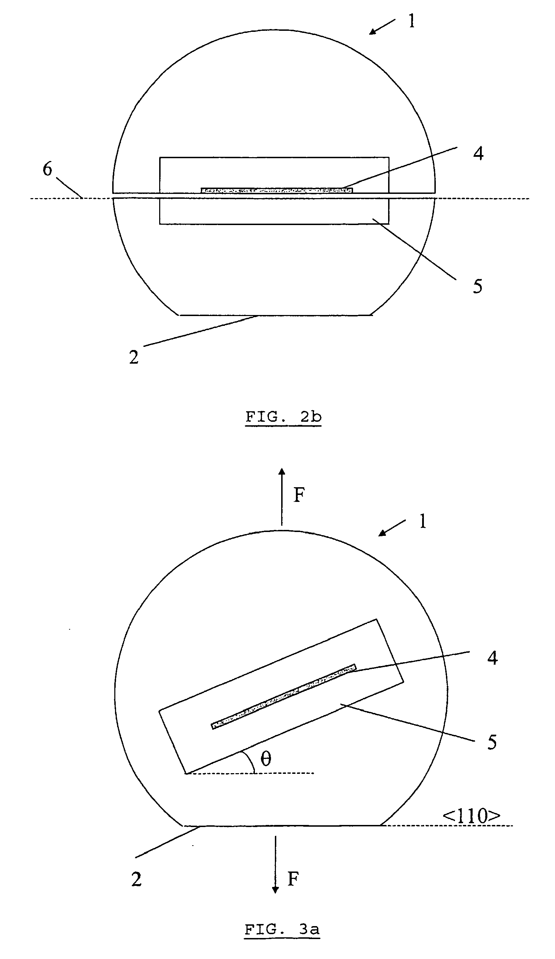

As stated above, the flat of standard Si-wafers is oriented along the <110> direction. Suppose that the opening 4 is now parallel to said flat, as shown in figure 2a. Even a relatively low tensile stress σ, as shown in figure 2a, will cause a critical stress at the tip of the opening. If a critical stress level is reached, cleavage will occur along the line 6 of figure 2b. The cleavage plane depends on the orientation of the stress and the type of stress. A tensile stress or a bending stress may cause cleavage along a plane of the {110} or {111} families. This is because not only the $K_c$ factor is important, but also the projection of the stress perpendicular to the cleavage plane. To decrease the chance of cleavage along any of these planes, the present invention now proposes the following solutions.

The present invention proposes a method of processing a wafer, wherein openings are etched at an angle θ with respect to the direction <110>, so that crack propagation is inhibited. More in particular, the longitudinal axis of the openings is at an angle θ to said direction, the axis being defined as a straight line parallel to the wafer and to the longitudinal dimension of the openings. In the case of a rectangular opening, this axis is typically the rectangular's longest symmetry axis.

Figure 2a shows the standard situation. The opening 4 is oriented along the <110> direction. Under the influence of a tensile stress σ, perpendicular to <110>, cleavage will occur as soon as a critical stress level is reached.

Figure 3a shows a first alternative, whereby the device 5 and the opening 4 have been rotated over an angle θ, with respect to <110>. Returning to the exemplary case of a tensile stress perpendicular to the flat, it is now the projection of the crack length 2c on the <110> direction which is to be taken into consideration in order to assess the chance of cleavage along the same plane as in figure 2b.

Such cleavage will now occur starting from a higher stress level $\sigma_c$':

$$\sigma_c' = \frac{K_c}{\sqrt{c\pi\cos\theta}} \qquad (3)$$

which is an increase by a factor $\sqrt{1/\cos\theta}$ compared to equation (2). This way, the chance of failure of the wafer by cleavage along the same plane as in figure 2b has diminished.

The optimal value of θ depends on the material used. In the case of silicon for example, the orientation along θ will decrease the chance of cleavage along one plane, but care must be taken that cleavage will not occur along another plane.

This may happen when the projection of the stress on the direction perpendicular to the opening 4, becomes high enough to initiate cleavage along another plane than the one that was 'reinforced' by tilting the opening 4.

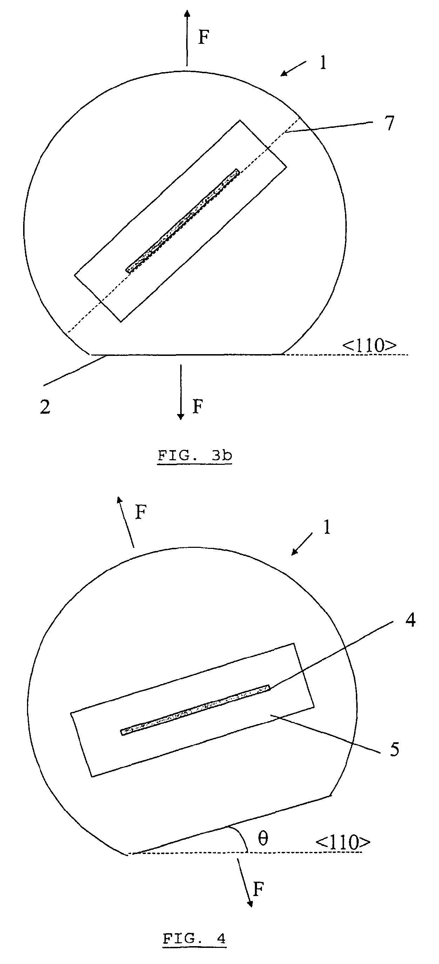

For Si-wafers, the optimal value of θ is lying between 0° and 45°: at 45°, the opening lies along the <100> direction, which may lead to cleavage along another plane of the {110} family and along a line 7 shown in figure 3b.

Figure 4 illustrates the second alternative, wherein the flat of the wafer is no longer oriented along the <110>, but along a direction which is at an angle θ with respect to that <110> direction. The device 5 and the opening 4 remain parallel to the flat, as in the case of standard wafers.

To have a similar situation than the previous, the wafer of figure 4 is once again subjected to a tensile stress σ perpendicular to the flat. To assess the chance of the wafer breaking along the same cleavage plane as before, the relevant crack length to be taken into consideration is the projection of the real crack length 2c on the <110> direction. However, this projected length is now subjected to the projection of σ on the direction perpendicular to <110>. This means that cleavage will now occur when:

$$\sigma\cos\theta \rangle \frac{K_c}{\sqrt{\pi c\cos\theta}} \qquad (4)$$

meaning:

$$\sigma \rangle \frac{K_c}{\cos\theta.\sqrt{\pi c\cos\theta}} \qquad (5)$$

In this case, the critical stress at which cleavage along the same plane as in figure 2b occurs is further increased by a factor 1/cosθ.

Based on the two effects described above, two preferred embodiments of the method according to the invention are proposed. According to both embodiments, a wafer is subjected to a process comprising the steps of photolithography and etching, known in the art. The photolithography entails the printing of a pattern of dies, such as shown in figure 1a or 1c onto a wafer. This printing step may be performed in different ways. In all cases, the pattern to be printed is produced on a so-called mask, to be placed between a light source and the wafer, in order to print the pattern onto said wafer. In one type of printing, the mask is placed in contact with or very close to the wafer. This is called contact or proximity printing respectively, which are used preferably to print a complete set of dies (as in figures 1a or 1c). On the other hand, projection printing methods exist, whereby an optical system is employed between the mask and the wafer, which allows the printed pattern to be reduced in size with respect to the pattern on the mask. This last method is preferably used when a number of different dies with equal size are printed next to each other on the same wafer, a process also called step-and-repeat printing.

In a first preferred embodiment, illustrated in figure 3a, openings are oriented on a standard wafer so that they are placed at an angle θ with respect to the flat and thus to the <110> direction.

According to this embodiment, micromachined devices are produced by a method comprising the steps of photolithography and etching of a Si-wafer, wherein the photolithography step preferably comprises a contact or proximity printing step. To acquire the tilting of the complete set of dies over an angle θ, different actions can be undertaken: the mask can be rotated over that angle with respect to a stationary wafer, prior to photo-exposure of the pattern. This would of course require a printing device which allows such a rotation. Alternatively, the pattern on the mask may placed in a tilted position, at an angle θ with respect to the mask, and then printed through the mask while the mask is in its standard position. This allows the use of a standard printing device. Finally, the wafer itself can be rotated over θ, with respect to a stationary and standard printing device and standard mask. The wafer used in this embodiment of the invention is a standard wafer, with the flat oriented along the <110> direction.

In a second embodiment, illustrated in figure 4, openings are parallel to the flat, but the flat itself is tilted at an angle θ with respect to the <110> direction. This type of wafer is not standard and needs to be produced especially in this way.

According to this embodiment, the production method of micromachined devices comprises equally the classic photolithography and etching steps, whereby the photolithography step may equally comprise a contact or proximity printing step. The tilted orientation of the flat with respect to the weaker <110> direction, permits the printing of the set of dies, according to standard processing methods, without necessitating the rotation of the mask, nor of the wafer.

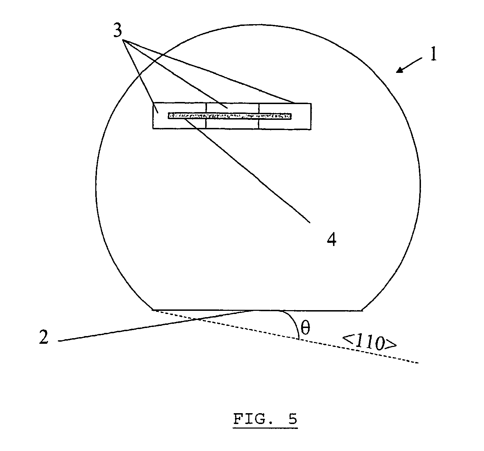

Apart from that, the method according to the second embodiment of the invention is especially suitable for a method wherein the photolithography is based on projection printing, such as step-and-repeat printing, as illustrated in figure 5. As was stated before, this type of printing step is mostly used to acquire a set of dies 3 of identical dimensions, such as shown in figures 1a and 1b. In step-and-repeat printing, the dies 3 are printed separately and consecutively onto the wafer 1. To obtain an orientation of the die and/or the openings defined on it, on a standard wafer (i.e. with the flat parallel to <110>), it would be necessary to perform additional translation/rotation of the wafer between printing steps, in order to align the different dies, which would make the method more complex and time-consuming. With the wafer used in the method according to this embodiment, whereby the flat is not oriented along the <110> direction, the wafer can be processed in the classic way, without additional translation or rotation between printing steps.

Table 1

| Miller index plane | {100} | {110} | {111} |
|---|---|---|---|
| Kc $(MPA\sqrt{m}$ MPA$)$ | 0.95 | 0.9 | 0.82 |

## Claims

1. A method for producing micromachined devices for use in Microelectromechanical Systems (MEMS), said devices having improved resistance to crack propagation, comprising the steps of:

   - providing a silicon wafer (1) whose front and back surfaces are oriented along a plane of the {100} family,
   - processing from said wafer at least one micromachined device (5) comprising at least one elongated opening and/or cavity, having a longitudinal axis, so that said longitunal axis is at an angle to a direction which lies along the intersection of the front plane of the wafer and a cleavage plane,

   **characterized in that** said cleavage plane is a plane belonging to the {111} or {110} family, and wherein said angle between said longitudinal axis of said opening and/or cavity and said intersection is more than 0 but less than 44°.

2. A method according to claim 1, wherein said wafer (1) has the shape of a circular disc, with at least one part cut off along a chord of said circular disc, the longest of said chords being called 'the flat' (2) of said wafer.

3. A method according to claim 2 wherein said flat (2) is not parallel to said intersection.

4. A method according to claim 2, wherein said flat (2) is parallel to said intersection.

5. A method according to claim 4, wherein said processing comprises the steps of :

- subjecting said wafer (1) to a photolithography step, whereby a pattern is printed through a mask onto said wafer,
- etching said wafer,

**characterised in that** said photolithography step comprises the step of rotating said mask over an angle, with respect to said wafer.

6. A method according to claim 4, wherein said processing comprises the steps of :

- subjecting said wafer (1) to a photolithography step, whereby a pattern is printed through a mask onto said wafer,
- etching said wafer,

wherein said pattern is positioned at an angle with respect to said mask.

7. A method according to claim 4, wherein said processing comprises the steps of :

- subjecting said wafer to a photolithography step, whereby a pattern is printed through a mask onto said wafer,
- etching said wafer,

**characterised in that** said photolithography step comprises the step of rotating said wafer over an angle with respect to said mask.

8. A method according to any one of claims 5 to 7, wherein said photolithography step comprises a contact printing step.

9. A method according to any one of claims 5 to 7, wherein said photolithography step comprises a proximity printing step.

10. A method according to claim 3, wherein said processing comprises the steps of:

- subjecting said wafer to a photolithography step, whereby a pattern is printed through a mask onto said wafer,
- etching said wafer.

11. A method according to claim 10, wherein said photolithography step comprises a number of projection printing steps.

12. A method according to claim 10, wherein said photolithography step comprises a contact printing step.

13. A method according to claim 10, wherein said photolithography step comprises a proximiy printing step.


**Patentansprüche**

1. Verfahren zum Herstellen von mikrobearbeiteten Vorrichtungen zur Verwendung in Mikroelektromechanischen Systemen (MEMS), wobei die Vorrichtungen einen verbesserten Widerstand gegen Rissausbreitung aufweisen, welches die folgenden Schritte umfasst:

- Bereitstellen eines Siliziumwafers (1), dessen vordere und hintere Flächen entlang einer Ebene der {100}-Schar ausgerichtet sind;
- Bearbeiten des Wafers auf mindestens einer mikrobeartbeiteten Vorrichtung (5), die mindestens eine längliche Öffnung und/oder Höhlung umfasst, welche eine Längsachse hat, so dass die Längsachse einen Winkel mit der Richtung bildet, die an der Schnittlinie der vorderen Ebene des Wafers und einer Spaltfläche liegt,

**dadurch gekennzeichnet, dass** die Spaltebene eine Ebene ist, welche zur {111}- oder {110}-Schar gehört und wobei der Winkel zwischen der Längsachse der Öffnung und/oder Höhlung und der Schnittlinie größer als 0, aber kleiner als 44° ist.

2. Verfahren nach Anspruch 1, wobei der Wafer (1) die Form einer Kreisscheibe hat, wobei mindestens ein Teil entlang einer Sehne der Kreisscheibe abgeschnitten ist, wobei die längste der Sehnen 'die Abflachung' (flat) (2) des Wafers genannt wird.

**3.** Verfahren nach Anspruch 2, wobei die Abflachung (2) nicht parallel zur Schnittlinie ist.

**4.** Verfahren nach Anspruch 2, wobei die Abflachung (2) parallel zur Schnittlinie ist.

**5.** Verfahren nach Anspruch 4, wobei die Verarbeitung die folgenden Schritte umfasst:

- Ausführen eines Fotolithografieschritts am Wafer (1), wodurch ein Muster durch eine Maske auf den Wafer gedruckt ist,
- Ätzen des Wafers,

**dadurch gekennzeichnet, dass** der Fotolithografieschritt den Schritt des Drehens der Maske um einen Winkel gegenüber dem Wafer umfasst.

**6.** Verfahren nach Anspruch 4, wobei die Verarbeitung die folgenden Schritte umfasst:

- Ausführen eines Fotolithografieschritts am Wafer (1), wodurch ein Muster durch eine Maske auf den Wafer gedruckt ist,
- Ätzen des Wafers,

wobei das Muster unter einem Winkel gegenüber der Maske angeordnet ist.

**7.** Verfahren nach Anspruch 4, wobei die Verarbeitung die folgenden Schritte umfasst:

- Ausführen eines Fotolithografieschritts am Wafer, wodurch ein Muster durch eine Maske auf den Wafer gedruckt ist,
- Ätzen des Wafers,

**dadurch gekennzeichnet, dass** der Fotolithografieschritt den Schritt des Drehens des Wafers um einen Winkel gegenüber der Maske umfasst.

**8.** Verfahren nach einem der Ansprüche 5 bis 7, wobei der Fotolithografieschritt einen Schritt von Kontacktbelichtung umfasst.

**9.** Verfahren nach einem der Ansprüche 5 bis 7, wobei der Fotolithografieschritt einen Schritt von Proximity-Belichtung umfasst.

**10.** Verfahren nach Anspruch 3, wobei die Verarbeitung die folgenden Schritte umfasst:

- Ausführen eines Fotolithografieschritts am Wafer, wodurch ein Muster durch eine Maske auf den Wafer gedruckt ist,
- Ätzen des Wafers.

**11.** Verfahren nach Anspruch 10, wobei der Fotolithografieschritt eine Reihe von Schritten von Projektionsbelichtung umfasst.

**12.** Verfahren nach Anspruch 10, wobei der Fotolithografieschritt einen Schritt von Kontaktbelichtung umfasst.

**13.** Verfahren nach Anspruch 10, wobei der Fotolithografieschritt einen Schritt von Proximity-Belichtung umfasst.

**Revendications**

**1.** Procédé de production de dispositifs micro-usinés à utiliser dans des systèmes microélectromécaniques (MEMS), lesdits dispositifs ayant une résistance améliorée à la propagation de fissure, comprenant les étapes consistant à :

- fournir une tranche en silicium (1) dont les surfaces avant et arrière sont orientées le long d'un plan de la famille {100},
- traiter à partir de ladite tranche, au moins un dispositif micro-usiné (5) comprenant au moins une ouverture et/ou cavité allongée, ayant un axe longitudinal, de sorte que ledit axe longitudinal fait un angle par rapport à une direction qui se trouve le long de l'intersection du plan avant de la tranche et d'un plan de clivage,

**caractérisé en ce que** ledit plan de clivage est un plan appartenant à la famille {111} ou {110}, et où ledit angle entre ledit axe longitudinal de ladite ouverture et/ou cavité et ladite intersection est supérieur à 0 mais inférieur à 44°.

2. Procédé selon la revendication 1, dans lequel ladite tranche (1) a la forme d'un disque circulaire, avec au moins une partie coupée le long d'une corde dudit disque circulaire, la plus longue desdites cordes étant appelée « le plat » (2) de ladite tranche.

3. Procédé selon la revendication 2, dans lequel ledit plat (2) n'est pas parallèle à ladite intersection.

4. Procédé selon la revendication 2, dans lequel ledit plat (2) est parallèle à ladite intersection.

5. Procédé selon la revendication 4, dans lequel ledit traitement comprend les étapes consistant à :

- soumettre ladite tranche (1) à une étape de photolithographie, par laquelle un motif est imprimé par l'intermédiaire d'un masque sur ladite tranche,
- graver ladite tranche,

**caractérisé en ce que** ladite étape de photolithographie comprend l'étape de rotation dudit masque sur un angle, par rapport à ladite tranche.

6. Procédé selon la revendication 4, dans lequel ledit traitement comprend les étapes consistant à :

- soumettre ladite tranche (1) à une étape de photolithographie, par laquelle un motif est imprimé par l'intermédiaire d'un masque sur ladite tranche,
- graver ladite tranche,

où ledit motif est positionné à un angle par rapport audit masque.

7. Procédé selon la revendication 4, dans lequel ledit traitement comprend les étapes consistant à :

- soumettre ladite tranche à une étape de photolithographie, par laquelle un motif est imprimé par l'intermédiaire d'un masque sur ladite tranche,
- graver ladite tranche,

**caractérisé en ce que** ladite étape de photolithographie comprend l'étape de rotation de ladite tranche sur un angle par rapport audit masque.

8. Procédé selon l'une quelconque des revendications 5 à 7, dans lequel ladite étape de photolithographie comprend une étape d'impression par contact.

9. Procédé selon l'une quelconque des revendications 5 à 7, dans lequel ladite étape de photolithographie comprend une étape d'impression par proximité.

10. Procédé selon la revendication 3, dans lequel ledit traitement comprend les étapes consistant à :

- soumettre ladite tranche à une étape de photolithographie, par laquelle un motif est imprimé par l'intermédiaire d'un masque sur ladite tranche,
- graver ladite tranche.

11. Procédé selon la revendication 10, dans lequel ladite étape de photolithographie comprend un certain nombre d'étapes d'impression par projection.

12. Procédé selon la revendication 10, dans lequel ladite étape de photolithographie comprend une étape d'impression par contact.

**13.** Procédé selon la revendication 10, dans lequel ladite étape de photolithographie comprend une étape d'impression par proximité.

FIG. 1a

FIG. 1b

1

2

FIG. 1c

F

1

4

5

σ

σ

<110>

2

F

FIG. 2a

FIG. 2b

FIG. 3a

FIG. 3b

FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0658927 A
- US 4969359 A
- EP 0562880 A
- DE 3435138 A
- US 4278987 A
- JP 03219618 A

**Non-patent literature cited in the description**

- **P.J. Burnett.** Properties of Silicon. *EMIS datareview series no. 4, INSPEC,* 1988, 30